# EUROPÄISCHE PATENTSCHRIFT

(11) **EP 2 331 453 B1**
(45) Veröffentlichungstag und Bekanntmachung des Hinweises auf die Patenterteilung: **11.07.2012**
(21) Anmeldenummer: 09781417.2
(22) Anmeldetag: 03.08.2009
(51) Int. Cl.: B81B 7/00

(54) **MIKROMECHANISCHES BAUELEMENT MIT DURCHGANGSELEKTRODE UND VERFAHREN ZU DESSEN HERSTELLUNG**
MICROMECHANICAL COMPONENT HAVING THROUGH ELECTRODE AND METHOD FOR THE PRODUCTION THEREOF
COMPOSANT MICRO-MÉCANIQUE AYANT UNE ELECTRODE TRAVERSANTE ET PROCÉDÉ DE PRODUCTION ASSOCIÉ

(30) Priorität: 25.09.2008 DE 102008042350
(43) Veröffentlichungstag der Anmeldung: 15.06.2011
(73) Patentinhaber: Robert Bosch GmbH, 70442 Stuttgart (DE)
(72) Erfinder: FEYH, Ando, 71732 Tamm (DE)
(86) Internationale Anmeldenummer: PCT/EP2009/060025
(87) Internationale Veröffentlichungsnummer: WO 2010/034552

(56) Entgegenhaltungen:
- EP-A1- 0 623 824
- DE-A1- 4 445 553
- DE-A1-102007 060 931
- US-A1- 2006 275 946

## Beschreibung

Die Erfindung betrifft ein mikromechanisches Bauelement mit einem ersten Substrat und einem mit dem ersten Substrat verbundenen zweiten Substrat, wobei das erste Substrat eine Mikrostruktur mit einem beweglichen Funktionselement aufweist, und wobei das erste und zweite Substrat derart miteinander verbunden sind, dass das Funktionselement von einem Hohlraum umschlossen ist. Die Erfindung betrifft weiter ein Verfahren zum Herstellen eines solchen Bauelements.

### Stand der Technik

Mikromechanische Bauelemente, welche beispielsweise im Automobilbereich als Inertial- oder Beschleunigungssensoren zum Einsatz kommen, weisen üblicherweise eine Mikrostruktur mit beweglichen Funktionselementen auf. Die Mikrostruktur wird auch als MEMS-Struktur (Micro-Electro-Mechanical System) bezeichnet. Im Betrieb der Sensoren wird eine Auslenkung eines Funktionselements zum Beispiel durch eine Änderung der elektrischen Kapazität gegenüber einer festen Bezugselektrode erfasst.

Ein gängiges Verfahren zum Herstellen eines mikromechanischen Bauelements umfasst das Ausbilden der Mikrostruktur auf einem Funktionssubstrat, und ein Verbinden des Funktionssubstrats mit einem Kappensubstrat durch ein sogenanntes Wafer-Bonding-Verfahren. Auf diese Weise wird ein die Funktionselemente umschließender Hohlraum ausgebildet, durch welchen die Funktionselemente hermetisch von der Umgebung abgedichtet sind. Neben der Mikrostruktur werden ferner vergrabene Leiterbahnen in dem Funktionssubstrat ausgebildet, welche unterhalb der Funktionsstruktur angeordnet sind. Diese können als Elektroden zum kapazitiven Erfassen der Auslenkung von Funktionselementen eingesetzt werden sowie einen elektrischen Pfad zu Kontaktelementen (Bondpads) außerhalb der rahmenförmigen Kappe bereitstellen. Die Verkappung des Funktionssubstrats wird üblicherweise in einer vorgegebenen Gas- bzw. Druckatmosphäre durchgeführt, um in dem Hohlraum eine entsprechende Druckatmosphäre einzustellen. Als Klebemittel zum Verbinden von Funktions- und Kappensubstrat wird ein Sealglas (Glaslot) eingesetzt, welches beispielsweise mit Hilfe eines Siebdruckverfahrens auf das Kappensubstrat aufgebracht wird.

Dieser Aufbau des Bauelements ist mit einer Reihe von Nachteilen verbunden. Die Ausbildung der vergrabenen Leiterbahnen, welche zu Kontaktelementen neben die MEMS-Struktur bzw. außerhalb der Kappe führen, hat einen hohen Flächenbedarf des Bauelements zur Folge. Des Weiteren ist das Verfahren komplex und erfordert eine große Anzahl an Prozessschritten. Beispielsweise kann das Verfahren den Einsatz von mehr als zehn lithographischen Strukturierungsebenen bzw. - verfahren mit sich bringen, wodurch sich hohe Herstellungskosten für den Gesamtprozess ergeben. Auch sind in dem Verfahrensablauf kritische Prozessschritte enthalten, welche beispielsweise zu einer Unterätzung einer vergrabenen Leiterbahn führen können. Der Einsatz des Sealglases führt ferner zu einem relativ breiten Bondrahmen, wodurch das Bauelement weiter vergrößert wird. Darüber hinaus ist das Sealglas beim Aufbringen mit einem Lösungsmittel versetzt, welches beim Bondverfahren ausgetrieben wird. Problematisch ist jedoch, dass ein Restanteil des Lösungsmittels in dem Sealglas zurückbleiben kann, und daher in den Hohlraum ausgasen und den vorgegebenen Druck verändern kann.

Die DE 44 45 553 A1 beschreibt einen Halbleiterbeschleunigungssensor und ein Verfahren zu dessen Herstellung. Bei dem Verfahren werden ein mit einer bewegbaren Elektrode versehenes Funktionssubstrat und ein Kappensubstrat miteinander verbunden. Das Kappensubstrat wird mit einer Elektrode ausgebildet, welche der bewegbaren Elektrode des Funktionssubstrats gegenüberliegt und zur Aufwärtsbewegung der bewegbaren Elektrode verwendet wird.

Die DE 10 2007 060 931 A1 bezieht sich auf ein weiteres mikromechanisches Bauelement und ein zugehöriges Herstellungsverfahren. Bei dem Verfahren werden ebenfalls ein Funktionssubstrat und ein Kappensubstrat miteinander verbunden. Das Funktionssubstrat weist bewegliche Funktionselemente, und das Kappensubstrat weist den Funktionselementen gegenüberliegende Elektroden auf.

Die US 2006/0275946 A1 beschreibt die Herstellung eines weiteren Bauelements. Dabei werden ein Funktionssubstrat mit einer mikromechanischen Struktur ein Kappensubstrat miteinander verbunden. Das Funktionssubstrat weist Durchkontaktierungen zum Kontaktieren der mikromechanischen Struktur auf.

Die EP 0 623 824 A1 bezieht sich auf die Herstellung eines weiteren Bauelements, wobei mehrere übereinander angeordnete Halbleitersubstrate miteinander verbunden werden. Hierbei weist ein mittig angeordnetes Substrat eine auslenkbare Masse auf. An entgegen gesetzten Seiten der Substratanordnung vorgesehene Substrate sind mit Elektroden ausgebildet

### Offenbarung der Erfindung

Die Aufgabe der vorliegenden Erfindung besteht darin, ein verbessertes Verfahren zum Herstellen eines mikromechanischen

Bauelements und ein verbessertes mikromechanisches Bauelement anzugeben, bei dem die oben beschriebenen Nachteile vermieden werden.

Diese Aufgabe wird durch ein Verfahren gemäß Anspruch 1 und durch ein mikromechanisches Bauelement gemäß Anspruch 7 gelöst. Weitere vorteilhafte Weiterbildungen der Erfindung sind in den abhängigen Ansprüchen angegeben.

Erfindungsgemäß wird ein Verfahren zum Herstellen eines mikromechanischen Bauelements vorgeschlagen. Das Verfahren umfasst ein Bereitstellen eines ersten Substrats und ein Ausbilden einer Mikrostruktur auf dem ersten Substrat, wobei die Mikrostruktur ein bewegliches Funktionselement aufweist. Das Verfahren umfasst weiter ein Bereitstellen eines zweiten Substrats und ein Ausbilden einer Elektrode in dem zweiten Substrat zum kapazitiven Erfassen einer Auslenkung des Funktionselements. Das erste und das zweite Substrat werden verbunden, wobei ein abgeschlossener Hohlraum gebildet wird, welcher das Funktionselement umschließt, und wobei die Elektrode an den Hohlraum in einem Bereich des Funktionselements angrenzt

Da das zweite Substrat eine Elektrode zum kapazitiven Erfassen einer Auslenkung des Funktionselements aufweist, kann auf die Ausbildung einer vergrabenen Leiterbahn in dem ersten Substrat und eines mit der Leiterbahn verbundenen Kontaktelements seitlich versetzt zu der Mikrostruktur verzichtet werden. In Folge dessen kann das mikromechanische Bauelement mit einer geringen Bauteilgröße verwirklicht werden. Auch lässt sich das Bauelement mit einer relativ geringen Anzahl an Strukturierungsebenen bzw. Prozessschritten herstellen, wodurch das Verfahren einfach und kostengünstig ist. Ferner liegen keine kritischen Prozessschritte mit Negativfolgen wie die oben genannte Leiterbahnunterätzung vor, so dass auch keine aufwändigen Maßnahmen zum Verhindern derartiger Effekte erforderlich sind. Erfindungsgemäß umfasst das Ausbilden der Elektrode das Ausbilden einer Isolationsstruktur in dem zweiten Substrat Über die Isolationsstruktur wird ein Substratbereich in dem zweiten Substrat eingefasst, welcher als Elektrode dient.

Gemäß einer bevorzugten Ausführungsform wird die Mikrostruktur mit einer ersten metallischen Schicht ausgebildet. Eine zweite metallische Schicht wird auf dem zweiten Substrat ausgebildet. Das Verbinden des ersten und zweiten Substrats erfolgt über die erste und zweite metallische Schicht. Auf diese Weise kann eine hermetisch dichte und platzsparende Verbindung zwischen den beiden Substraten ermöglicht werden. Auch besteht keine Gefahr einer Ausgasung, wodurch der Hohlraum mit einem sehr geringen bzw. definierten Druck ausgebildet werden kann. Ein Verbindungsverfahren, welches vorzugsweise zum Einsatz kommt, ist eutektisches Bonden oder Thermokompressionsbonden.

Gemäß einer weiteren bevorzugten Ausführungsform wird nach dem Verbinden des ersten und zweiten Substrats Substratmaterial an einer rückseitigen Oberfläche des zweiten Substrats abgetragen, um die Elektrode an der rückseitigen Oberfläche freizulegen, so dass diese von extern kontaktiert werden kann. Da das Abtragen von Substratmaterial erst nach dem Verbinden der Substrate durchgeführt wird, kann das zweite Substrat in den vorangehenden Verfahrensschritten eine relativ große Dicke aufweisen, wodurch sich das Verfahren einfacher durchführen lässt. Nach dem Abtragen des Substratmaterials kann des Weiteren eine Metallisierung auf der rückseitigen Oberfläche des zweiten Substrats ausgebildet werden, welche die freigelegte Elektrode kontaktiert.

Gemäß einer weiteren bevorzugten Ausführungsform wird in dem zweiten Substrat ein das zweite Substrat durchdringender Anschluss ausgebildet. Über den Anschluss kann eine elektrische

Verbindung zu der Mikrostruktur durch das zweite Substrat hindurch hergestellt werden.

Erfindungsgemäß wird ferner ein mikromechanisches Bauelement vorgeschlagen. Das Bauelement weist ein erstes Substrat und ein mit dem ersten Substrat verbundenes zweites Substrat auf. Das erste Substrat weist eine Mikrostruktur mit einem beweglichen Funktionselement auf. Das erste und zweite Substrat sind derart miteinander verbunden, dass das Funktionselement von einem abgeschlossenen Hohlraum umschlossen ist. Das mikromechanische Bauelement zeichnet sich dadurch aus, dass das zweite Substrat eine Elektrode zum kapazitiven Erfassen einer Auslenkung des Funktionselements aufweist, wobei die Elektrode an den Hohlraum in einem Bereich des Funktionselements angrenzt. Durch die Anordnung der Elektrode in dem zweiten Substrat kann das Bauelement auf einfache Weise, kostengünstig und mit einer geringen Baugröße hergestellt werden.

### Kurze Beschreibung der Zeichnungen

Die Erfindung wird im Folgenden anhand der Figuren näher erläutert. Es zeigen:

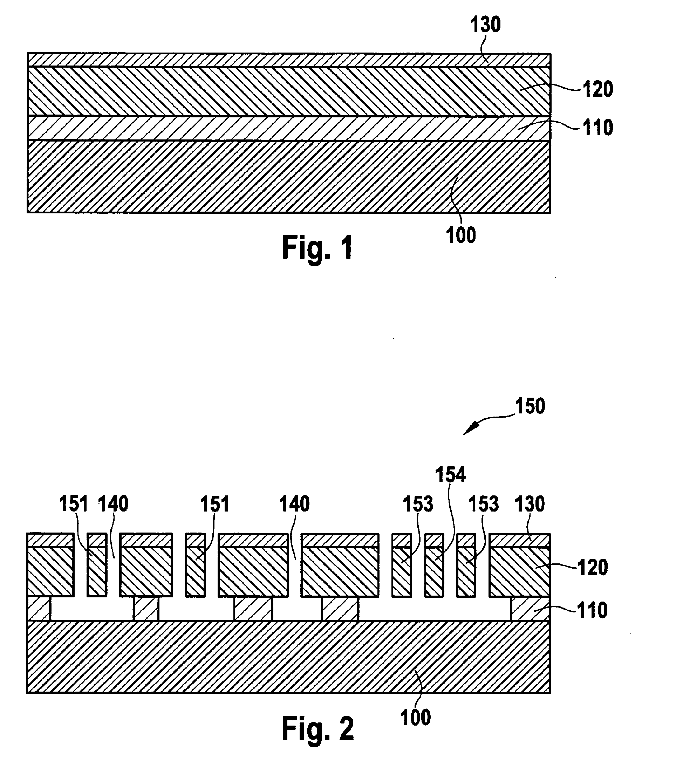

Figuren 1 bis 7 ein Verfahren zur Herstellung eines mikromechanischen Bauelements, jeweils in einer seitlichen Schnittdarstellung.

### Ausführungsformen der Erfindung

Die folgenden Figuren 1 bis 7 zeigen schematisch die Herstellung eines mikromechanischen Bauelements 300, welches beispielsweise als Inertialsensor in einem Kraftfahrzeug einsetzbar ist. Bei der Herstellung können in der Halbleitertechnik übliche Prozesse und Materialien zum Einsatz kommen.

Die Figuren 1 und 2 zeigen die Herstellung eines Funktionssubstrats 100 mit einer mikromechanischen bzw. MEMS-Struktur 150 für das Bauelement 300. Zu Beginn wird ein Substrat 100 bereitgestellt, welches beispielsweise ein Halbleitermaterial wie zum Beispiel Silizium aufweist. Bei dem Substrat 100 kann es sich um einen gängigen Wafer mit einem Durchmesser von beispielsweise 8 Zoll (200 mm) handeln.

Nachfolgend werden auf das Substrat 100 wie in Figur 1 dargestellt eine Opferschicht 110 und auf die Opferschicht 110 eine Funktionsschicht 120 aufgebracht. Die Opferschicht 110 weist vorzugsweise Siliziumoxid auf. Bei der Funktionsschicht 120 kann es sich um eine sogenannte Epi-Polysiliziumschicht handeln, d.h. eine in einem Epitaxie-Verfahren erzeugte polykristalline Siliziumschicht. Optional kann die Funktionsschicht 120 zusätzlich dotiert ausgebildet werden, um die elektrische Leitfähigkeit zu erhöhen und/oder die Schicht 120 mit einer vorgegebenen mechanischen Spannung zu versehen. Der beschriebene Aufbau des Substrats 100 mit den Schichten 110, 120 kann alternativ durch ein sogenanntes SOI-Substrat (Silicon On Insulator) realisiert sein, wobei die Funktionsschicht 120 hierbei monokristallines Silizium aufweisen kann.

Auf die Funktionsschicht 120 wird ferner wie in Figur 1 dargestellt eine dünne metallische Schicht 130 aufgebracht. Die metallische Schicht 130 kann eine Dicke in einem Bereich von beispielsweise einigen 10 nm bis zu wenigen Mikrometern aufweisen. Als Material für die Schicht 130 kommen Metalle wie zum Beispiel Aluminium, Kupfer und Gold in Betracht. Möglich ist auch der Einsatz einer Metalllegierung wie zum Beispiel einer Alumnium-Silizium-Kupfer-Legierung.

Die metallische Schicht 130 wird wie in Figur 2 dargestellt strukturiert. Hierbei wird ein lithographisches Strukturierungsverfahren durchgeführt, bei dem zunächst eine strukturierte Photolackschicht auf der metallischen Schicht 130 erzeugt, und die metallische Schicht 130 in einem Ätzverfahren einer Strukturierung unterzogen wird. Die strukturierte metallische Schicht 130 wird nachfolgend als Maske zum Ätzen von Gräben 140 in die Funktionsschicht 120 verwendet. Über die Gräben 140 wird die Form einer auszubildenden Mikrostruktur 150 festgelegt. Das Grabenätzen kann beispielsweise mithilfe eines DRIE-Verfahrens (Deep Reactive Ion Etching) durchgeführt werden, bei dem ein anisotrop wirkendes Ätzplasma zum Einsatz kommt.

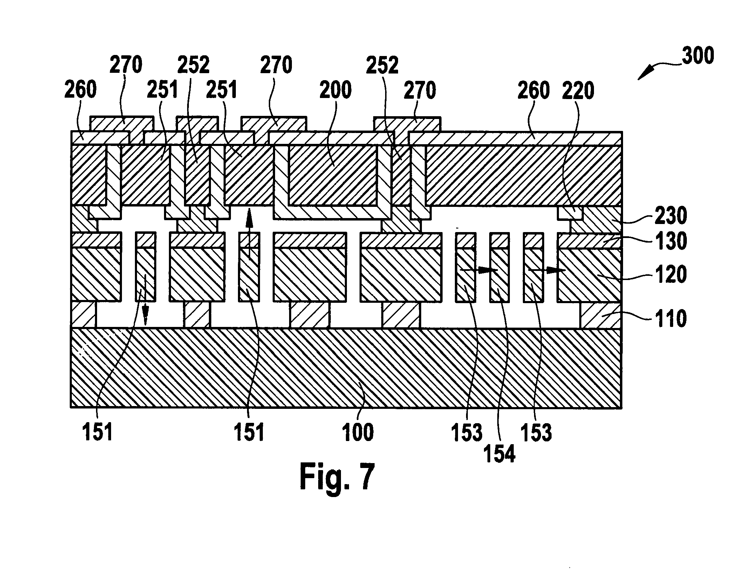

Zum Fertigstellen der Mikrostruktur 150 wird des weiteren ein Teil der Opferschicht 110 entfernt, um Elektrodenfinger bzw. Funktionselemente 151, 153, 154 wie in Figur 2 dargestellt freizulegen. Zu diesem Zweck wird ein Ätzmedium bzw. Ätzgas über die Gräben 140 an die Opferschicht 110 herangeführt. Für den Fall, dass die Opferschicht 110 wie oben beschrieben Siliziumoxid aufweist, kann hierbei beispielsweise Flusssäuredampf verwendet werden. Die Funktionselemente 151 bilden eine sogenannte z-Wippe, und sind daher für eine Auslenkung senkrecht zur Substratoberfläche ("z-Richtung") ausgebildet. Die Funktionselemente 153, 154 bilden eine Schwinger- oder Kammstruktur, wobei das Funktionselement 154 unbeweglich und die Funktionselemente 153 parallel zur Substratoberfläche ("x/y-Richtung") auslenkbar sind (vergl. Figur 7).

Nach dem Ätzen der Opferschicht 110 ist das Substrat 100 mit der Mikrostruktur 150 im wesentlichen fertig gestellt. Das Substrat 100 wird daher im Folgenden als Funktionssubstrat 100 bezeichnet. Da lediglich eine lithographische Strukturierung durchgeführt wird, ist die Herstellung des Funktionssubstrats 100 mit einem relativ geringen Aufwand verbunden.

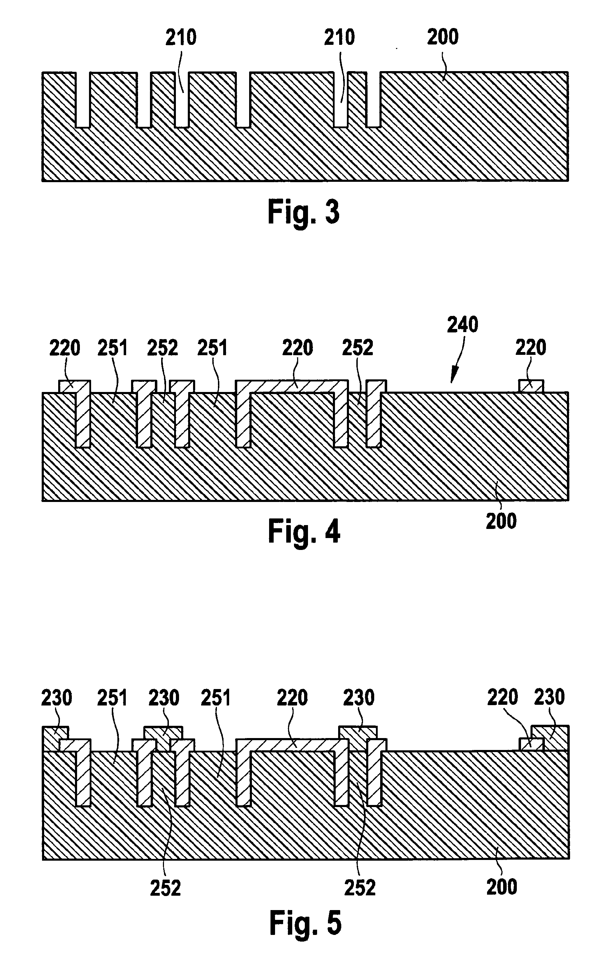

Die Figuren 3 bis 5 zeigen die Herstellung eines Kappensubstrats 200, welches mit dem Funktionssubstrat 100 zum Ausbilden des mikromechanischen Bauelements.300 verbunden wird. Das Kappensubstrat 200 dient hierbei nicht nur zur hermetischen Abdichtung der Funktionselemente 151, 153, 154, sondern wird zusätzlich für eine kapazitive Ankopplung und eine elektrische Ankontaktierung eingesetzt. Zu Beginn wird ein Substrat 200 bereitgestellt, welches ein Halbleitermaterial wie zum Beispiel Silizium aufweisen kann. Bei dem Substrat 200 kann es sich ebenfalls um einen Wafer mit einem Durchmesser von beispielsweise 8 Zoll handeln.

In dem bereitgestellten Substrat 200 werden wie in Figur 3 dargestellt Gräben 210 ausgebildet, welche wie weiter unten beschrieben zur Isolation und zur Definition von Substratbereichen für die kapazitive und elektrische Ankopplung dienen. Zum Ausbilden der Gräben 210 kann ein entsprechendes Lithographie- und ein Ätzverfahren (zum Beispiel DRIE-Verfahren) durchgeführt werden. Die Gräben 210 weisen beispielsweise eine Tiefe von einigen 10 bis wenigen 100 µm auf.

Im Anschluss hieran wird eine isolierende Schicht 220 großflächig auf das Substrat 200 unter Auffüllung der Gräben 210 aufgebracht. Die isolierende Schicht 220 weist beispielsweise ein Oxid oder alternativ ein anderes Dielektrikum wie zum Beispiel ein Nitrid auf. Im Rahmen eines weiteren lithographischen Strukturierungsverfahrens wird die isolierende Schicht 220 strukturiert, so dass sich die in Figur 4 dargestellte Ausgestaltung ergibt, bei welcher das Halbleitermaterial des Substrats 200 in Teilabschnitten offengelegt ist.

Über die in den Gräben 210 angeordnete isolierende Schicht 220 werden Substratbereiche eingefasst bzw. definiert, welche bei dem mikromechanischen Bauelement 300 als Elektroden 251 zur kapazitiven Auswertung und als Anschlüsse 252 zur elektrischen Ankontaktierung dienen. Weiter wird durch die strukturierte Schicht 220 an der Substratoberfläche im Bereich einer Elektrode 251 eine Aussparung bzw. Kavität definiert, welche eine Bewegung eines Funktionselements 151 in Richtung der Elektrode 251 ermöglicht. Eine entsprechende durch die Schicht 220 definierte Kavität bzw. Topographie 240 wird auch an einem anderen Abschnitt des Substrats 200 bereitgestellt, so dass eine ungehinderte Bewegung der Funktionselemente 153 in x/y-Richtung, d.h. senkrecht zur Bewegungsrichtung eines Funktionselements 151, ermöglicht wird.

Um die elektrische Leitfähigkeit der Elektroden 251 und Anschlüsse 252 zu erhöhen, kann optional eine Dotierung des Substrats 200 - vor oder nach Herstellung der Gräben 210 bzw. Ausbildung der strukturierten isolierenden Schicht 220 - erfolgen. Zu diesem Zweck kann zum Beispiel ein Phosphorglas (POCl3) auf das Substrat 200 aufgebracht und nachfolgend ein Temperaturschritt durchgeführt werden, um Phosphor als Dotierstoff in das Substrat 200 einzubringen.

Nachfolgend wird eine metallische Schicht 230 auf das Substrat 200 bzw. die Schicht 220 aufgebracht und mithilfe eines lithographischen Strukturierungsverfahrens strukturiert, so dass das Kappensubstrat 200 im wesentlichen fertig gestellt ist (Figur 5). Hinsichtlich möglicher Materialien für die metallische Schicht 230 wird auf die obigen Ausführungen zur metallischen Schicht 130 des Funktionssubstrats 100 verwiesen. Ein Teil der metallischen Schicht 230 ist auf den Anschlüssen 252 angeordnet und dient zu deren Kontaktierung.

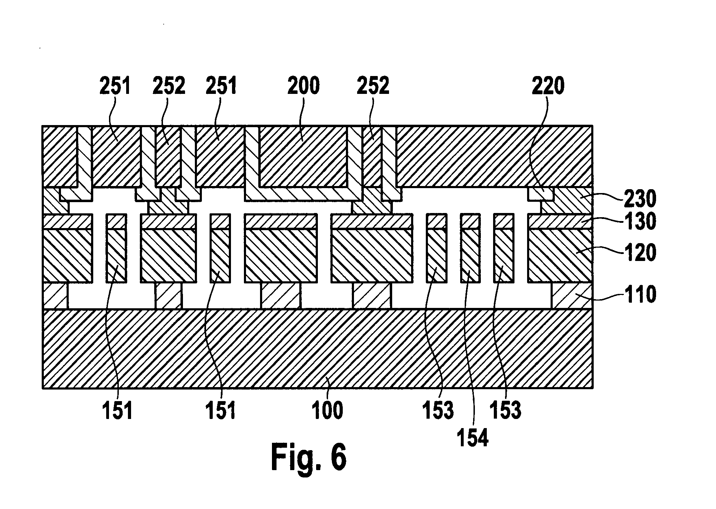

Darüber hinaus wird die metallische Schicht 230 des Kappensubstrats 200 zusammen mit der metallischen Schicht 130 des Funktionssubstrats 100 dazu eingesetzt, die beiden Substrate 100, 200 im Rahmen eines Wafer-Bonding-Verfahrens mechanisch stabil miteinander zu verbinden (Figur 6). Durch die Verbindung der beiden Substrate 100, 200 wird ein bzw. werden mehrere die Funktionselemente 151, 153, 154 umschließende Hohlräume gebildet, welche über die als Dichtrahmen fungierenden Schichten 130, 230 hermetisch gegenüber der Umgebung abgedichtet sind. Die Substrate 100, 200 werden ferner derart verbunden, dass eine Elektrode 251 an einen Hohlraum in einem Bereich über einem Funktionselement 151 angrenzt.

Zum Verbinden der Substrate 100, 200 wird vorzugsweise ein eutektischer Bondprozess durchgeführt, bei dem die beiden metallischen Schichten 130, 230 unter Temperatureinwirkung eine eutektische Legierung bilden. Alternativ ist es möglich, ein Thermokompressionsbonden durchzuführen, bei dem die Schichten 130, 230 durch Temperatureinwirkung und Aneinanderpressen der Substrate 100, 200 zu einer gemeinsamen Schicht verbunden werden. Aus Gründen der Übersichtlichkeit sind die Schichten 130, 230 in den Figuren 6 und 7 jedoch weiterhin als einzelne Schichten dargestellt. Im Hinblick auf die genannten Bondverfahren sind die Materialien der Schichten 130, 230 entsprechend aufeinander abgestimmt.

Das Verbinden der beiden Substrate 100, 200 wird ferner bei einer definierten Atmosphäre mit einem vorgegebenen (beispielsweise sehr geringen) Druck durchgeführt, um einen definierten Druck in dem bzw. den Hohlräumen zwischen den beiden Substraten 100, 200 einzustellen. Durch die Verbindung über die metallischen Schichten 130, 230 besteht keine Gefahr einer Ausgasung, so dass der einmal eingestellte Druck keiner weiteren Änderung unterliegt. Die Verbindung über die Schichten 130, 230 ist darüber hinaus elektrisch leitfähig, und kann gegenüber einer Sealglas-Verbindung platzsparender (geringere Breite des Dichtrahmens) verwirklicht werden.

Nach dem Verbinden der beiden Substrate 100, 200 wird ferner Substratmaterial an einer rückseitigen Oberfläche des Kappensubstrats 200 bis wenigstens zu der isolierenden Schicht 220 abgetragen. Auf diese Weise werden die über die isolierende Schicht 220 definierten Elektroden 251 und Anschlüsse 252 an der rückseitigen Oberfläche wie in Figur 6 dargestellt freigelegt, so dass die Elektroden 251 und Anschlüsse 252 das Substrat 200 bzw. dessen Halbleitermaterial vollständig durchdringen. Das Abtragen an der Substratrückseite kann beispielsweise durch Rückschleifen (zum Beispiel CMP, Chemisch Mechanisches Polieren) erfolgen. Auch das Funktionssubstrat 100 kann in einem entsprechenden Abtrag- bzw. Schleifprozess rückgedünnt werden.

Des weiteren wird wie in Figur 7 dargestellt eine weitere isolierende Schicht 260 großflächig auf der rückseitigen Oberfläche des Kappensubstrats 200 aufgebracht, und diese im Rahmen eines lithographischen Strukturierungsverfahrens strukturiert, so dass die Elektroden 251 und Anschlüsse 252 wiederum teilweise freigelegt werden. Hierbei können ferner Sägemarken in die Schicht 260 für eine Vereinzelung eingebracht werden. Nachfolgend wird eine weitere metallische Schicht 270 großflächig auf der rückseitigen Oberfläche des Substrats 200 bzw. auf der isolierenden Schicht 260 aufgebracht und lithographisch strukturiert, um die Elektroden 251 und Anschlüsse 252 mit einer Metallisierung zu versehen, über welche die Elektroden 251 und Anschlüsse 252 von extern kontaktiert werden können. Im Anschluss hieran kann ein Vereinzelungsprozess durchgeführt werden, wodurch das mikromechanische Bauelement 300 im wesentlichen fertig gestellt wird.

Das Bauelement 300 weist drei Verdrahtungsebenen auf, welche durch die mit der Metallschicht 130 bedeckte Funktionsschicht 120, die das Substrat 200 durchdringenden Anschlüsse bzw. Durchkontakte 252 und die Metallschicht 270 gebildet werden. Weiter weist das Bauelement 300 eine die Funktionselemente 151 umfassende z-Wippe und eine die Funktionselemente 153, 154 umfassende Schwingerstruktur auf, deren Schwingungsrichtungen in Figur 7 anhand von Pfeilen angedeutet werden.

Im Betrieb der z-Wippe des Bauelements 300 wird die Kapazität zwischen den Elektroden 251 und den als Bezugselektroden wirkenden Funktionselementen 151 gemessen, wobei eine Auslenkung der Funktionselemente 151 sich in einer Kapazitätsänderung niederschlägt. Hierbei können die Funktionselemente 151 über einen der z-Wippe zugeordneten Anschluss 252 und über die Schichten 230, 130, 120 kontaktiert werden. Um eine Differenzauswertung zu ermöglichen, können die Funktionselemente 151 wie in Figur 7 anhand der unterschiedlichen Pfeilrichtungen angedeutet für ein gegenläufiges Auslenken miteinander verbunden sein. Eine vergleichbare Funktionsweise ergibt sich für die Schwingerstruktur, wobei hier die Kapazität zwischen dem unbeweglichen Funktionselement 154 und den auslenkbaren Funktionselementen 153 gemessen wird. Die Funktionselemente 153, 154 können hierbei über zugehörige Anschlüsse 252 und über die Schichten 230, 130, 120 kontaktiert werden.

Durch die Anordnung der Elektroden 251 und Anschlüsse 252 in dem Kappensubstrat 200 über der Mikrostruktur 150 wird eine geringe Baugröße des Bauelements 300 ermöglicht. Auch basiert das Verfahren auf lediglich sechs lithographischen Strukturierungsebenen bzw. -prozessen, wodurch sich das Verfahren einfach und kostengünstig gestaltet. Als günstig erweist sich ferner, dass das Rückdünnen des Kappensubstrats 200 (und gegebenenfalls auch des Funktionssubstrats 100) erst nach dem Verbinden der Substrate 100, 200 durchgeführt wird, so dass die Substrate in den vorangehenden Verfahrensschritten eine relativ große Dicke aufweisen können.

Das anhand der Figuren erläuterte Verfahren und das mikromechanische Bauelement 300 stellen bevorzugte Ausführungsformen der Erfindung dar. Darüber hinaus lassen sich weitere Ausführungsformen verwirklichen, welche weitere Abwandlungen der Erfindung umfassen. Insbesondere können anstatt der angegebenen Materialien andere Materialien zum Einsatz kommen.

Eine Verbindung zwischen einem Funktions- und einem Kappensubstrat kann anstelle über zwei metallische Schichten auch über eine, beispielsweise auf dem Kappensubstrat aufgebrachte metallische Schicht erfolgen, welche in einem Bonding-Verfahren direkt mit einer Funktionsschicht verbunden wird. Ein hierfür in Betracht kommendes Beispiel ist eine eutektische Verbindungsbildung zwischen den Materialien Gold (metallische Schicht) und Silizium (Funktionsschicht).

Elektroden und Anschlüsse in einem Kappensubstrat können alternativ mithilfe eines "Through-Silicon-Via"-Verfahrens ausgebildet werden. Hierbei werden Gräben in dem Substrat ausgebildet, die Gräben mit einer isolierenden Schicht ausgekleidet, sowie nachfolgend die Gräben mit einer leitfähigen Schicht aufgefüllt.

Ein mikromechanisches Bauelement kann ferner mit einer anderen Anzahl an Funktionselementen verwirklicht werden. Ferner ist die Herstellung eines Bauelements möglich, welches lediglich eine oder mehrere z-Wippen und keine Schwingerstruktur aufweist, wobei die z-Wippen über Elektroden und Anschlüsse eines Kappensubstrats auswertbar sind.

## Patentansprüche

1. Verfahren zum Herstellen eines mikromechanischen Bauelements (300), umfassend die Verfahrensschritte:
Bereitstellen eines ersten Substrats (100);
Ausbilden einer Mikrostruktur (150) auf dem ersten Substrat (100) mit einem beweglichen Funktionselement (151);
Bereitstellen eines zweiten Substrats (200);
Ausbilden einer Elektrode (251) in dem zweiten Substrat (200) zum kapazitiven Erfassen einer Auslenkung des Funktionselements (151); und
Verbinden des ersten und zweiten Substrats (100; 200), wobei ein abgeschlossener Hohlraum gebildet wird, welcher das Funktionselement (151) umschließt, und
wobei die Elektrode (251) an den Hohlraum in einem Bereich des Funktionselements (151) angrenzt,
**dadurch gekennzeichnet,**
**dass** das Ausbilden der Elektrode (251) das Ausbilden einer Isolationsstruktur (210; 220) in dem zweiten Substrat (200) umfasst, welche einen Substratbereich in dem zweiten Substrat (200) einfasst.

2. Verfahren nach einem Anspruch 1, **dadurch gekennzeichnet, dass** die Mikrostruktur (150) mit einer ersten metallischen Schicht (130) ausgebildet wird, und dass eine zweite metallische Schicht (230) auf dem zweiten Substrat (200) ausgebildet wird, wobei das Verbinden des ersten und zweiten Substrats (100; 200) über die erste und zweite metallische Schicht (130; 230) erfolgt.

3. Verfahren nach einem der vorhergehenden Ansprüche, **dadurch gekennzeichnet, dass** das Verbinden des ersten und zweiten Substrats (100; 200) durch einen der folgenden Prozesse durchgeführt wird:
eutektisches Bonden; und
Thermokompressionsbonden.

4. Verfahren nach einem der vorhergehenden Ansprüche, **dadurch gekennzeichnet, dass** nach dem Verbinden des ersten und zweiten Substrats (100; 200) Substratmaterial an einer rückseitigen Oberfläche des zweiten Substrats (200) abgetragen wird, um die Elektrode (251) an der rückseitigen Oberfläche frelzulegen.

5. Verfahren nach Anspruch 4, **dadurch gekennzeichnet, dass** nach dem Abtragen von Substratmaterial eine Metallisierung (270) auf der rückseitigen Oberfläche des zweiten Substrats (200) ausgebildet wird, welche die freigelegte Elektrode (251) kontaktiert.

6. Verfahren nach einem der vorhergehenden Ansprüche, **dadurch gekennzeichnet, dass** ein Anschluss (252) in dem zweiten Substrat (200) ausgebildet wird, über welchen eine elektrische Verbindung durch das zweite Substrat (200) hindurch zu der Mikrostruktur (150) herstellbar ist.

7. Mikromechanisches Bauelement umfassend ein erstes Substrat (100) und ein mit dem ersten Substrat (100) verbundenes zweites Substrat (200), wobei das erste Substrat (100) eine Mikrostruktur (150) mit einem beweglichen Funktionselement (151) aufweist, wobei das erste und zweite Substrat (100; 200) derart miteinander verbunden sind, dass das Funktionselement (151) von einem abgeschlossenen Hohlraum urnschlossen ist, wobei das zweite Substrat (200) eine Elektrode (251) zum kapazitiven Erfassen einer Auslenkung des Funktionselements (151) aufweist, wobei die Elektrode (251) an den Hohlraum in einem Bereich des Funktionselements (151) angrenzt,
**dadurch gekennzeichnet,**
**dass** die Elektrode (251) in Form eines Substratbereichs des zweiten Substrats (200) ausgebildet ist, welcher von einer in dem zweiten Substrat (200) ausgebildeten Isolationsstruktur (210; 220) eingefasst ist.

8. Mikromechanisches Bauelement nach Anspruch 7, **dadurch gekennzeichnet, dass** die Elektrode (251) an einer rückseitigen Oberfläche des zweiten Substrats (200) kontaktierbar ist.

9. Mikromechanisches Bauelement nach einem der Ansprüche 7 oder 8, **gekennzeichnet durch** eine metallische Schicht (130; 230), über welche das erste und zweite Substrat (100; 200) miteinander verbunden sind.

10. Mikromechanisches Bauelement nach Anspruch 9, **dadurch gekennzeichnet, dass** das zweite Substrat (200) einen das zweite Substrat (200) durchdringenden Anschluss (252) zum Herstellen einer elektrischen Verbindung zu der Mikrostruktur (150) aufweist.

## Claims

1. Method for producing a micromechanical component (300), comprising the following method steps:
providing a first substrate (100);
forming a microstructure (150) on the first substrate (100) with a movable functional element (151);
providing a second substrate (200);
forming an electrode (251) in the second substrate (200) for capacitively detecting a deflection of the functional element (151); and
connecting the first and second substrates (100; 200), wherein a closed-off cavity is formed, which encloses the functional element (151), and wherein the electrode (251) adjoins the cavity in a region of the functional element (151),
**characterized**
**in that** forming the electrode (251) comprising forming an insulation structure (210; 220) in the second substrate (200), which insulation structure borders a substrate region in the second substrate (200).

2. Method according to Claim 1, **characterized in that** the microstructure (150) is formed with a first metallic layer (130), and **in that** a second metallic layer (230) is formed on the second substrate (200), wherein connecting the first and second substrates (100; 200) is effected via the first and second metallic layers (130; 230).

3. Method according to either of the preceding claims, **characterized in that** connecting the first and second substrates (100; 200) is carried out by means of one of the following processes:
eutectic bonding; and
thermocompression bonding.

4. Method according to any of the preceding claims, **characterized in that** after the first and second substrates (100; 200) have been connected, substrate material is removed at a rear-side surface of the second substrate (200) in order to uncover the electrode (251) at the rear-side surface.

5. Method according to Claim 4, **characterized in that** after substrate material has been removed, a metallization (270) is formed on the rear-side surface of the second substrate (200), which metallization makes contact with the uncovered electrode (251).

6. Method according to any of the preceding claims, **characterized in that** a terminal (252) is formed in the second substrate (200), via which terminal it is possible to produce an electrical connection through the second substrate (200) to the microstructure (150).

7. Micromechanical component comprising a first substrate (100) and a second substrate (200) connected to the first substrate (100) wherein the first substrate (100) has a microstructure (150) with a movable functional element (151), wherein the first and second substrates (100; 200) are connected to one another in such a way that the functional element (151) is enclosed by a closed-off cavity, wherein the second substrate (200) has an electrode (251) for capacitively detecting a deflection of the functional element (151), wherein the electrode (251) adjoins the cavity in a region of the functional element (151),
**characterized**
**in that** the electrode (251) is formed in the form of a substrate region of the second substrate (200) which is bordered by an insulation structure (210; 220) formed in the second substrate (200).

8. Micromechanical component according to Claim 7, **characterized in that** contact can be made with the electrode (251) at a rear-side surface of the second substrate (200).

9. Micromechanical component according to either of Claims 7 and 8, **characterized by** a metallic layer (130; 230), via which the first and second substrates (100; 200) are connected to one another.

10. Micromechanical component according to Claim 9, **characterized in that** the second substrate (200) has a terminal (252) penetrating through the second substrate (200) and serving for producing an electrical connection to the microstructure (150).

## Revendications

1. Procédé de fabrication d'un composant micromécanique (300), le procédé présentant les étapes suivantes :
préparer un premier substrat (100),
former sur le premier substrat (100) une microstructure (150) qui présente un élément fonctionnel (151) mobile,
préparer un deuxième substrat (200),
former dans le deuxième substrat (200) une électrode (251) destinée à détecter par voie capacitive une déviation de l'élément fonctionnel (151) et
relier le premier et le deuxième substrat (100; 200) en formant une cavité fermée qui englobe l'élément fonctionnel (151), l'électrode (251) étant adjacente à la cavité dans une partie de l'élément fonctionnel (151),
**caractérisé en ce que**
la formation de l'électrode (251) comporte la formation dans le deuxième substrat (200) d'une structure isolante (210; 220) qui englobe une partie du deuxième substrat (200).

2. Procédé selon la revendication 1, **caractérisé en ce que** la microstructure (150) est configurée avec une première couche métallique (130) et **en ce qu'**une deuxième couche métallique (230) est formée sur le deuxième substrat (200), la liaison du premier et du deuxième substrat (100; 200) s'effectuant par l'intermédiaire de la première et de la deuxième couche métallique (130; 230).

3. Procédé selon l'une des revendications précédentes, **caractérisé en ce que** la liaison du premier et du deuxième substrat (100; 200) est réalisée par l'une des opérations suivantes :
liaison eutectique et
liaison par thermocompression.

4. Procédé selon l'une des revendications précédentes, **caractérisé en ce qu'**après la liaison du premier et du deuxième substrat (100; 200), du matériau de substrat est enlevé sur une surface dorsale du deuxième substrat (200) pour libérer l'électrode (251) sur la surface dorsale.

5. Procédé selon la revendication 4, **caractérisé en ce qu'**après l'enlèvement du matériau du substrat, une métallisation (270) en contact avec l'électrode (251) libérée est formée sur la surface dorsale du deuxième substrat (200).

6. Procédé selon l'une des revendications précédentes, **caractérisé en ce qu'**un raccordement (252) par lequel une liaison électrique peut être établie avec la microstructure (150) à travers le deuxième substrat (200) est formée dans le deuxième substrat (200).

7. Composant micromécanique comprenant un premier substrat (100) et un deuxième substrat (200) relié au premier substrat (100),
le premier substrat (100) présentant une microstructure (150) dotée d'un élément fonctionnel (151) mobile,
le premier et le deuxième substrat (100; 200) étant reliés l'un à l'autre de telle sorte que l'élément fonctionnel (151) soit entouré par une cavité fermée,
le deuxième substrat (200) présentant une électrode (251) qui détecte par voie capacitive une déviation de l'élément fonctionnel (151),
l'électrode (251) étant adjacente à la cavité dans une partie de l'élément fonctionnel (151),
**caractérisé en ce que**
l'électrode (251) est configurée sous la forme d'une partie du deuxième substrat (200) entourée par une structure isolante (210; 220) formée dans le deuxième substrat (200).

8. Composant micromécanique selon la revendication 7, **caractérisé en ce qu'**un contact peut être établi avec l'électrode (251) sur une surface dorsale du deuxième substrat (200).

9. Composant micromécanique selon l'une des revendications 7 ou 8, **caractérisé par** une couche métallique (130; 230) par laquelle le premier et le deuxième substrat (100; 200) sont reliés mutuellement.

10. Composant micromécanique selon la revendication 9, **caractérisé en ce que** le deuxième substrat (200) présente un raccordement (252) qui traverse le deuxième substrat (200) en vue d'établir une liaison électrique avec la microstructure (150).
